# EUROPEAN PATENT APPLICATION

(11) **EP 4 650 804 A1**
(43) Date of publication of application: **19.11.2025**
(21) Application number: 24849442.9
(22) Date of filing: 22.07.2024
(51) Int. Cl.: G01R 31/392, G01R 31/382, G01R 31/396, G01R 19/12, B60L 58/10, H02J 7/00

(54) **APPARATUS AND METHOD FOR DIAGNOSING BATTERY**

(30) Priority: 03.08.2023 KR 20230101783
(71) Applicant: LG Energy Solution, Ltd., Seoul 07335 (KR)
(72) Inventor: NAM, Gi-Min, Daejeon 34122 (KR); HWANG, Tae-Hyun, Daejeon 34122 (KR); KIM, Hyeong-Seok, Daejeon 34122 (KR)
(74) Representative: Goddar, Heinz J.
(86) International application number: PCT/KR2024/010579
(87) International publication number: WO 2025/028873

(57) **Abstract**

An apparatus for diagnosing a battery according to an embodiment of the present disclosure includes a measuring unit configured to measure voltage and current of a battery; and a control unit configured to calculate a target discharge capacity until the voltage of the battery reaches a target voltage, calculate a full discharge capacity of the battery, calculate a capacity difference between the full discharge capacity and the target discharge capacity, calculate a capacity difference change rate based on the calculated capacity difference and a preset capacity difference profile, and diagnose a state of the battery based on the calculated capacity difference change rate and a preset criterion change rate.

## Description

### TECHNICAL FIELD

The present application claims priority to Korean Patent Application No. 10-2023-0101783 filed on August 3, 2023, in the Republic of Korea, the disclosures of which are incorporated herein by reference.

The present disclosure relates to an apparatus and method for diagnosing a battery, and more particularly, to an apparatus and method for diagnosing a battery, which may diagnose a state of a battery based on a capacity of the battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

In particular, it is necessary to prevent the phenomenon of lithium deposition on the surface of the negative electrode (lithium plating, Li-plating). If lithium is deposited on the surface of the negative electrode, it causes side reactions with the electrolyte and changes in the kinetic balance of the battery, which causes battery deterioration.

In addition, lithium plating may cause swelling of the battery. When swelling occurs in the battery, the center of the battery swells more than the edges of the battery, which may cause an uneven pressure distribution in the battery. This may cause problems such as a decrease in battery performance and a sudden death phenomenon in which the electrical connection is momentarily disconnected.

### DISCLOSURE

### Technical Problem

The present disclosure is designed to solve the problems of the related art, and therefore the present disclosure is directed to providing an apparatus and method for diagnosing a battery, which diagnoses a battery having a risk of sudden death based on a capacity of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a measuring unit configured to measure voltage and current of a battery; and a control unit configured to calculate a target discharge capacity until the voltage of the battery reaches a target voltage, calculate a full discharge capacity of the battery, calculate a capacity difference between the full discharge capacity and the target discharge capacity, calculate a capacity difference change rate based on the calculated capacity difference and a preset capacity difference profile, and diagnose a state of the battery based on the calculated capacity difference change rate and a preset criterion change rate.

The control unit may be configured to diagnose the state of the battery as a normal state when the calculated capacity difference change rate is less than the criterion change rate.

The control unit may be configured to diagnose the state of the battery as an abnormal state when the calculated capacity difference change rate is greater than or equal to the criterion change rate.

The control unit may be configured to diagnose the battery diagnosed as in the abnormal state as a battery having a risk of sudden death.

The control unit may be configured to determine a capacity difference of a previous time point from the capacity difference profile, and calculate a change rate between the calculated capacity difference and the capacity difference of the previous time point to calculate the capacity difference change rate.

The control unit may be configured to calculate a capacity difference change rate of the previous time point based on the capacity difference profile and set the criterion change rate as a value obtained by multiplying the capacity difference change rate of the previous time point by a preset criterion ratio.

The criterion ratio may be set as a ratio between a capacity difference change rate at a time point where sudden death occurs in a preset reference battery and a capacity difference change rate at a time point immediately before the sudden death occurs.

The target voltage may be preset as a voltage of a criterion battery corresponding to a negative electrode potential at which a change rate of a negative electrode potential with respect to the capacity is equal to a preset reference change rate in a negative electrode criterion profile of the criterion battery.

A battery pack according to another aspect of the present disclosure may comprise the apparatus for diagnosing a battery according to one aspect of the present disclosure.

A vehicle according to still another aspect of the present disclosure may comprise the apparatus for diagnosing a battery according to one aspect of the present disclosure.

A method for diagnosing a battery according to still another aspect of the present disclosure may comprise: a discharge capacity calculation step of calculating a target discharge capacity until a voltage of a battery reaches a target voltage and calculating a full discharge capacity of the battery; a capacity difference calculation step of calculating a capacity difference between the full discharge capacity and the target discharge capacity; a capacity difference change rate calculation step of calculating a capacity difference change rate based on the calculated capacity difference and a preset capacity difference profile; and a state diagnosis step of diagnosing a state of the battery based on the calculated capacity difference change rate and a preset criterion change rate.

### Advantageous Effects

According to one aspect of the present disclosure, the state of the battery may be accurately diagnosed based on the capacity difference change rate at the current time point.

In addition, according to one aspect of the present disclosure, since the capacity difference change rate of the battery is monitored, the risk of sudden death may be diagnosed early.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a drawing showing a battery profile showing the corresponding relationship between the voltage and capacity of a battery according to an embodiment of the present disclosure.
FIG. 3 is a drawing schematically showing a capacity difference by cycle of an abnormal battery.
FIG. 4 is a drawing schematically showing a capacity difference by cycle of a normal battery.
FIG. 5 is a drawing schematically illustrating the capacity difference by time point of the battery according to an embodiment of the present disclosure.
FIG. 6 is a drawing schematically illustrating the capacity difference and capacity difference change rate by time point of the battery according to an embodiment of the present disclosure.
FIG. 7 is a drawing schematically illustrating a criterion profile of a criterion battery according to an embodiment of the present disclosure.
FIG. 8 is a diagram schematically showing an exemplary configuration of a battery pack according to another embodiment of the present disclosure.
FIG. 9 is a diagram schematically showing an exemplary configuration of a vehicle according to still another embodiment of the present disclosure.
FIG. 10 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

The battery refers to an independent cell that has a negative electrode terminal and a positive electrode terminal and is physically separable. As an example, a lithium-ion cell or a lithium polymer cell may be considered a battery. Also, the battery may also mean a battery module having a plurality of cells connected in series and/or in parallel. Below, for convenience of explanation, a battery is described as meaning a single independent cell.

Hereinafter, a preferred embodiment of the present disclosure will be described in detail with reference to the accompanying drawings.

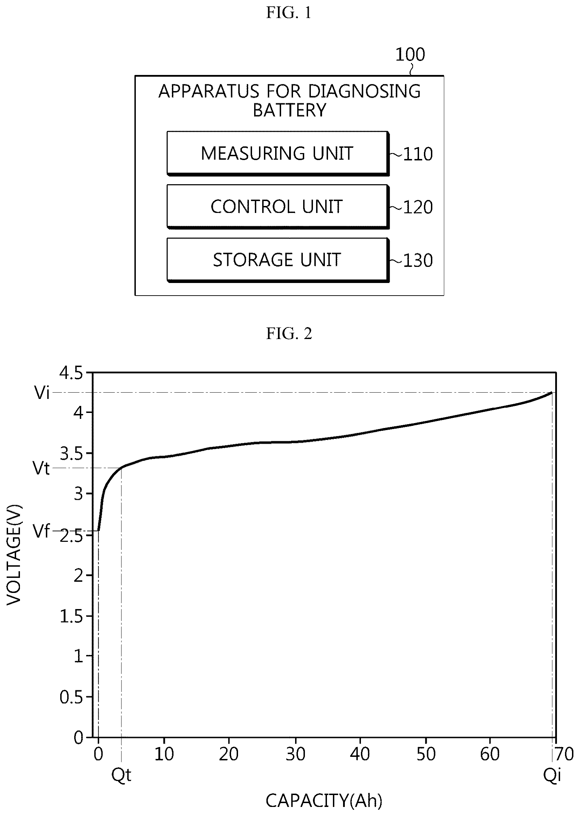

FIG. 1 is a diagram schematically illustrating an apparatus 100 for diagnosing a battery according to an embodiment of the present disclosure.

Referring to FIG. 1, the apparatus 100 for diagnosing a battery may include a measuring unit 110 and a control unit 120.

The measuring unit 110 may be configured to measure the voltage and current of the battery.

Specifically, the measuring unit 110 may measure the positive electrode potential and the negative electrode potential of the battery. In addition, the measuring unit 110 may measure the voltage of the battery by calculating the potential difference between the positive electrode potential and the negative electrode potential.

In addition, the measuring unit 110 may be connected to a current measurement element provided in the charge and discharge path of the battery. That is, the current measurement element may be connected to a high current path through which the charge current and discharge current of the battery flow. In addition, the measuring unit 110 may be connected to the current measurement element to measure the current of the battery. In addition, the measuring unit 110 may measure the charge current and discharge current of the battery using the current measurement element.

Also, the measuring unit 110 may be connected to communicate with the control unit 120. For example, the measuring unit 110 may be connected to the control unit 120 via wires and/or wirelessly. The measuring unit 110 may transmit voltage information and current information of the measured battery to the control unit 120.

For example, the measuring unit 110 may measure the voltage and current of the battery during the charging process of the battery, and transmit the measured battery information (voltage information and current information) to the control unit 120. As another example, the measuring unit 110 may measure the voltage and current of the battery during the discharging process of the battery, and transmit the measured battery information to the control unit 120.

The control unit 120 may be configured to calculate the target discharge capacity until the voltage of the battery reaches the target voltage.

Specifically, the battery may be discharged until the voltage reaches the target voltage from the predetermined charge end voltage. Here, the predetermined charge end voltage may be preset to any voltage greater than the target voltage in the available voltage range of the battery. For example, it is assumed that the available voltage range of the battery is 2.5 [V] to 4.2 [V], and the target voltage is Vt [V]. The charge end voltage may be any voltage selected from a voltage range greater than Vt [V] and less than or equal to 4.2 [V]. Preferably, the charge end voltage may be a voltage corresponding to SOC (state of charge) 100%. Hereinafter, this discharge process is called a first discharge mode.

Specifically, the control unit 120 may calculate the discharge capacity of the battery using the current counting method (ampere counting method, coulomb counting method).

Preferably, the measuring unit 110 may measure the current of the battery for each current measurement cycle until the voltage of the battery reaches the target voltage from the charge end voltage. The control unit 120 may calculate the target discharge capacity by accumulating the current from the charge end voltage until the voltage of the battery reaches the target voltage based on the current information received from the measuring unit 110.

The control unit 120 may be configured to calculate the full discharge capacity of the battery.

Specifically, the battery may be discharged until the voltage reaches a predetermined discharge end voltage from the predetermined charge end voltage. Here, the predetermined charge end voltage is the same as the charge end voltage of the first discharge mode. The discharge end voltage may be preset to any voltage less than the target voltage in the available voltage range of the battery. For example, as in the previous embodiment, it is assumed that the available voltage range of the battery is 2.5 [V] to 4.2 [V] and the target voltage is Vt [V]. The discharge end voltage may be any voltage selected from a voltage range greater than or equal to 2.5 [V] and less than Vt [V]. Preferably, the discharge end voltage may be a voltage corresponding to SOC 0%. Hereinafter, this discharge process is called a second discharge mode.

Specifically, the measuring unit 110 may measure the current of the battery for each current measurement cycle until the voltage of the battery reaches the discharge end voltage from the charge end voltage. The control unit 120 may calculate the target discharge capacity by accumulating the current from the charge end voltage to the discharge end voltage of the battery based on the current information received from the measuring unit 110.

In one embodiment, the first discharge mode and the second discharge mode may be performed at different time points. For example, in the first discharge mode, the voltage of the battery may be discharged from the charge end voltage to the target voltage. After a predetermined rest time, the battery may be charged again to the charge end voltage. Then, after another predetermined rest time, the voltage of the battery may be discharged from the charge end voltage to the discharge end voltage in the second discharge mode. Conversely, the second discharge mode, the rest time, the charge period, the rest time, and the first discharge mode may be performed in that order. The control unit may calculate the discharge amount of the first discharge mode to derive the target discharge capacity, and may calculate the discharge amount of the second discharge mode to derive the full discharge capacity.

In another embodiment, the first discharge mode and the second discharge mode may be performed in one discharge process. For example, the battery may be discharged until the voltage of the battery reaches the discharge end voltage from the charge end voltage. Here, the discharge from the charge end voltage to the target voltage may be referred to as a first discharge mode, and the discharge from the charge end voltage to the discharge end voltage may be referred to as a second discharge mode. The control unit may calculate the discharge amount from the charge end voltage to the target voltage in the discharge profile of the battery to derive the target discharge capacity, and may calculate the discharge amount from the charge end voltage to the discharge end voltage to derive the full discharge capacity.

FIG. 2 is a drawing showing a battery profile showing the corresponding relationship between the voltage and capacity of a battery according to an embodiment of the present disclosure.

In the embodiment of FIG. 2, the charge end voltage of the battery is Vi [V], the target voltage is Vt [V], and the discharge end voltage is Vf [V]. The capacity corresponding to the charge end voltage (Vi) is Qi [Ah], the capacity corresponding to the target voltage (Vt) is Qt [Ah], and the capacity corresponding to the discharge end voltage (Vf) is Qf [Ah]. The control unit 120 may calculate the target discharge capacity until the voltage of the battery reaches the target voltage (Vt) from the charge end voltage (Vi). In addition, the control unit 120 may calculate the full discharge capacity until the voltage of the battery reaches the discharge end voltage (Vf) from the charge end voltage (Vi).

The control unit 120 may be configured to calculate the capacity difference between the full discharge capacity and the target discharge capacity.

Specifically, the control unit 120 may calculate the difference between the target discharge capacity and the full discharge capacity. For example, the control unit 120 may calculate the capacity difference by calculating the formula "full discharge capacity - target discharge capacity."

For example, in the embodiment of FIG. 2, the capacity difference may be calculated according to the formula "(Qi - Qf) - (Qi - Qt)".

The control unit 120 may be configured to calculate a capacity difference change rate based on the calculated capacity difference and a preset capacity difference profile.

Here, the capacity difference profile may be a profile in which the values of the capacity difference calculated at the previous time points are stored. For example, if the current time point is the n-th time point (where n is a natural number greater than or equal to 2), the capacity difference profile may store the values of the capacity difference calculated at the first time point (t1) to the n-1-th time point for each time point. If the current time point is the first time point (t1), no capacity difference may be stored in the capacity difference profile. In addition, if the current time point is the second time point (t2), the capacity difference profile may store the capacity difference calculated at the first time point (t1).

Specifically, the control unit 120 may calculate a capacity difference change rate between the calculated capacity difference and the capacity difference of the previous time point included in the capacity difference profile. Preferably, the control unit 120 may calculate a change rate between the capacity difference calculated at the current time point and the capacity difference calculated at the latest time point. Here, the latest time point means a time point at which the capacity difference is calculated most recently, excluding the current time point.

Meanwhile, the time point at which the capacity difference is calculated may be periodic or non-periodic. If the time point at which the capacity difference is calculated is non-periodic, the larger the time point interval between the current time point and the previous time point, the larger the capacity difference change rate may be. Therefore, the control unit 120 may calculate the capacity difference change rate for the unit time in order to reduce the influence of the time point interval at which the capacity difference is calculated. That is, the control unit 120 may calculate the capacity difference change rate between the capacity difference of the current time point and the capacity difference of the previous time point by considering the time point interval between the current time point and the previous time point. For example, the control unit 120 may calculate the capacity difference change rate by calculating the formula "(capacity difference of the current time point - capacity difference of the previous time point) ÷ (time point interval between the current time point and the previous time point)".

The control unit 120 may be configured to diagnose the state of the battery based on the calculated capacity difference change rate and a preset criterion change rate.

Specifically, the control unit 120 may compare the size of the calculated capacity difference change rate and the criterion change rate, and diagnose the state of the battery based on the comparison result.

For example, if the calculated capacity difference change rate is less than the criterion change rate, the control unit 120 may be configured to diagnose the state of the battery as a normal state. Conversely, if the calculated capacity difference change rate is greater than or equal to the criterion change rate, the control unit 120 may be configured to diagnose the state of the battery as an abnormal state.

More specifically, an abnormal battery may be a battery in which the capacity difference between the full discharge capacity and the target discharge capacity changes rapidly. This rapid change in the capacity difference is due to lithium precipitation. Specifically, a rapid change in the capacity difference occurs in a battery in which battery swelling occurs due to lithium plating and which has a risk of sudden death due to swelling.

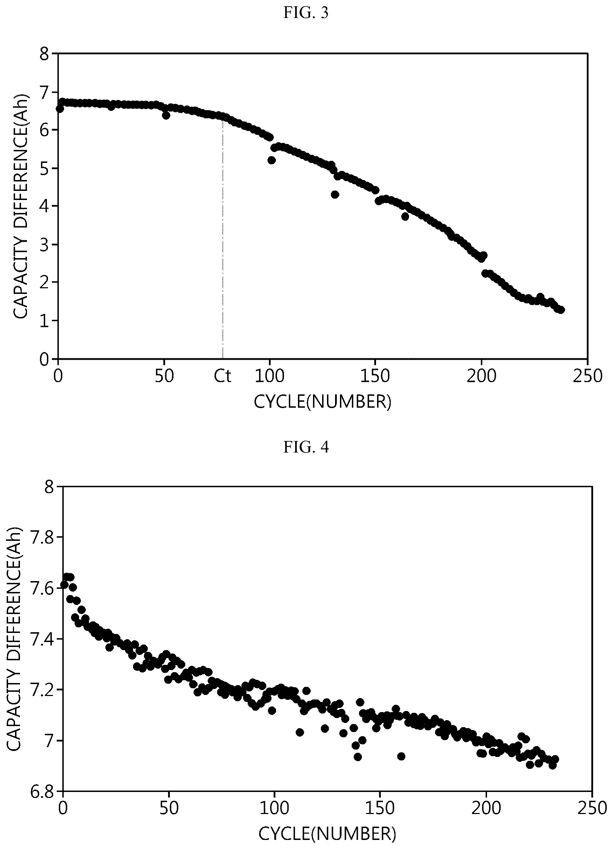

FIG. 3 is a drawing schematically showing a capacity difference by cycle of an abnormal battery. Specifically, the abnormal battery is a battery in which sudden death occurs due to lithium plating. FIG. 4 is a drawing schematically showing a capacity difference by cycle of a normal battery. Specifically, the normal battery is a battery in which lithium plating does not occur.

In the embodiment of FIG. 3, the capacity difference of the abnormal battery may be rapidly reduced from a specific cycle (Ct). That is, the capacity difference change rate in the specific cycle (Ct) may be greater than or equal to the criterion change rate. On the other hand, in the embodiment of FIG. 4, the capacity difference of the normal battery may be gradually reduced. Accordingly, the control unit 120 may be configured to diagnose a battery diagnosed as an abnormal state as a battery having a risk of sudden death.

The apparatus 100 for diagnosing a battery according to an embodiment of the present disclosure has an advantage in that it may accurately diagnose the state of the battery based on the capacity difference change rate of the current time point. That is, since the capacity difference change rate of the battery is monitored, the risk of sudden death may be diagnosed early.

Meanwhile, the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, information that may be used by the control unit 120 to diagnose the state of the battery, such as target discharge capacity, full discharge capacity, capacity difference profile, and criterion change rate, may be stored in the storage unit 130. The control unit 120 may access the storage unit 130 to obtain such information.

Meanwhile, in the above embodiment, an embodiment in which the control unit 120 diagnoses the state of the battery based on the capacity difference between the full discharge capacity and the target discharge capacity has been described. However, the factors that can be considered by the control unit 120 are not limited to the capacity difference.

For example, the control unit 120 may calculate the capacity retention rate for the capacity difference for each time point. Here, the capacity retention rate may be calculated according to the formula of "capacity difference of current time point ÷ initial capacity difference". Then, the control unit 120 may diagnose the state of the battery as a normal state or an abnormal state by comparing the change rate of the capacity retention rate and the criterion change rate. However, since the capacity retention rate is a value obtained by dividing the capacity difference by the initial capacity difference, the result of comparing the change rate of the capacity retention rate and the criterion change rate may be the same as the result of comparing the change rate of the capacity difference and the criterion change rate.

Below, an embodiment in which control unit 120 diagnoses the battery state is specifically described.

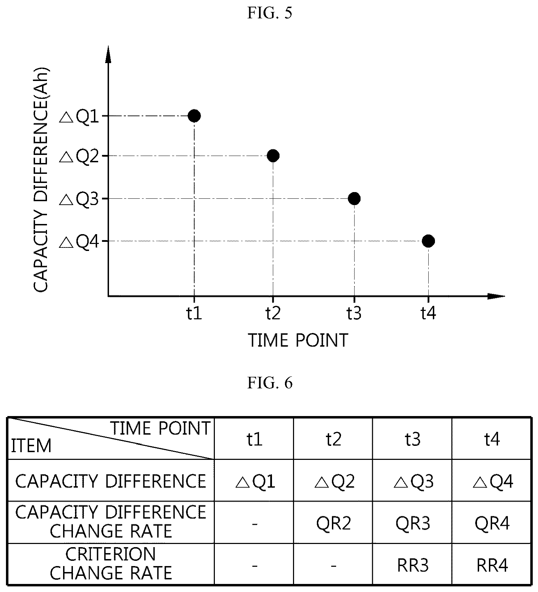

FIG. 5 is a drawing schematically illustrating the capacity difference by time point of the battery according to an embodiment of the present disclosure. FIG. 6 is a drawing schematically illustrating the capacity difference and capacity difference change rate by time point of the battery according to an embodiment of the present disclosure.

Specifically, FIG. 5 is a diagram illustrating a first capacity difference (ΔQ1) calculated at a first time point (t1), a second capacity difference (ΔQ2) calculated at a second time point (t2), a third capacity difference (ΔQ3) calculated at a third time point (t3), and a fourth capacity difference (ΔQ4) calculated at a fourth time point (t4). FIG. 6 is a diagram illustrating a capacity difference, a capacity difference change rate, and a criterion change rate at the first to fourth time points (t1, t2, t3, t4).

The control unit 120 may be configured to determine the capacity difference of a previous time point in the capacity difference profile.

In the embodiment of FIG. 6, the previous time point of the second time point (t2) is the first time point (t1), the previous time point of the third time point (t3) is the second time point (t2), and the previous time point of the fourth time point (t4) is the third time point (t3).

The control unit 120 may be configured to calculate a capacity difference change rate by calculating a change rate between the calculated capacity difference and the capacity difference of a previous time point.

In the embodiment of FIG. 6, the second capacity difference change rate (QR2) may be calculated based on the difference between the second capacity difference (ΔQ2) of the second time point (t2) and the first capacity difference (ΔQ1) of the first time point (t1). For example, the second capacity difference change rate (QR2) may be calculated according to the formula of "(ΔQ2 - ΔQ1) ÷ (t2 - t1)". Also, the third capacity difference change rate (QR3) may be calculated based on the difference between the third capacity difference (ΔQ3) of the third time point (t3) and the second capacity difference (ΔQ2) of the second time point (t2). For example, the third capacity difference change rate (QR3) may be calculated according to the formula of "(ΔQ3 - ΔQ2) ÷ (t3 - t2)". Finally, the fourth capacity difference change rate (QR4) may be calculated based on the difference between the fourth capacity difference (ΔQ4) at the fourth time point (t4) and the third capacity difference (ΔQ3) at the third time point (t3). For example, the fourth capacity difference change rate (QR4) may be calculated according to the formula "(ΔQ4 - ΔQ3) ÷ (t4 - t3)".

In addition, the control unit 120 may diagnose the state of the battery based on the result of comparing the calculated capacity difference change rate and the criterion change rate.

For example, in the embodiment of FIG. 6, since the first capacity difference change rate is not calculated at the first time point (t1), the criterion change rate is not set. Further, although the second capacity difference change rate (QR2) is calculated at the second time point (t2), the criterion change rate is not set because the first capacity difference change rate is not calculated. The control unit 120 may diagnose the state of the battery at the third time point (t3) based on the result of comparing the third capacity difference change rate (QR3) and the third criterion change rate (RR3). In addition, the control unit 120 may diagnose the state of the battery at the fourth time point (t4) based on the result of comparing the fourth capacity difference change rate (QR4) and the fourth criterion change rate (RR4).

Below, an embodiment in which control unit 120 sets the criterion change rate is described.

The control unit 120 may be configured to calculate the capacity difference change rate of the previous time point based on the capacity difference profile. In addition, the control unit 120 may be configured to set a value obtained by multiplying the capacity difference change rate of the previous time point by a preset criterion ratio as the criterion change rate.

Here, the criterion ratio may be set as the ratio between the capacity difference change rate of the time point at which sudden death occurs in the preset reference battery and the capacity difference change rate of the latest time point at which sudden death occurs.

In the embodiment of FIG. 6, the third criterion change rate (RR3) may be set according to the formula of "second capacity difference change rate (QR2) × criterion ratio". Also, the fourth criterion change rate (RR4) may be set according to the formula of "third capacity difference change rate (QR3) × criterion ratio".

In other words, if the ratio of the capacity difference change rate of the current time point to the capacity difference change rate of the previous time point is greater than or equal to the criterion ratio, the control unit 120 may diagnose the state of the battery as an abnormal state. That is, since the criterion ratio is a value set to reflect the state of a reference battery in which sudden death has occurred, if the capacity difference change rate of the current time point differs from the capacity difference change rate of the previous time point by more than the criterion ratio, the control unit 120 diagnoses the state of the battery as an abnormal state.

For example, in the embodiment of FIG. 6, if the third capacity difference change rate (QR3) is greater than or equal to the third criterion change rate (RR3), the control unit 120 may diagnose the state of the battery at the third time point (t3) as an abnormal state. Conversely, if the third capacity difference change rate (QR3) is less than the third criterion change rate (RR3), the control unit 120 may diagnose the state of the battery at the third time point (t3) as a normal state.

As another example, in the embodiment of FIG. 6, if the fourth capacity difference change rate (QR4) is greater than or equal to the fourth criterion change rate (RR4), the control unit 120 may diagnose the state of the battery at the fourth time point (t4) as an abnormal state. Conversely, if the fourth capacity difference change rate (QR4) is less than the fourth criterion change rate (RR4), the control unit 120 may diagnose the state of the battery at the fourth time point (t4) as a normal state.

The apparatus 100 for diagnosing a battery according to an embodiment of the present disclosure may effectively track and diagnose the change in the state of a battery by setting a criterion change rate of a current time point in consideration of a capacity difference change rate of a previous time point. That is, since the apparatus 100 for diagnosing a battery does not apply the criterion change rate to all time points uniformly but sets it for each time point, the current state of the battery may be diagnosed more accurately.

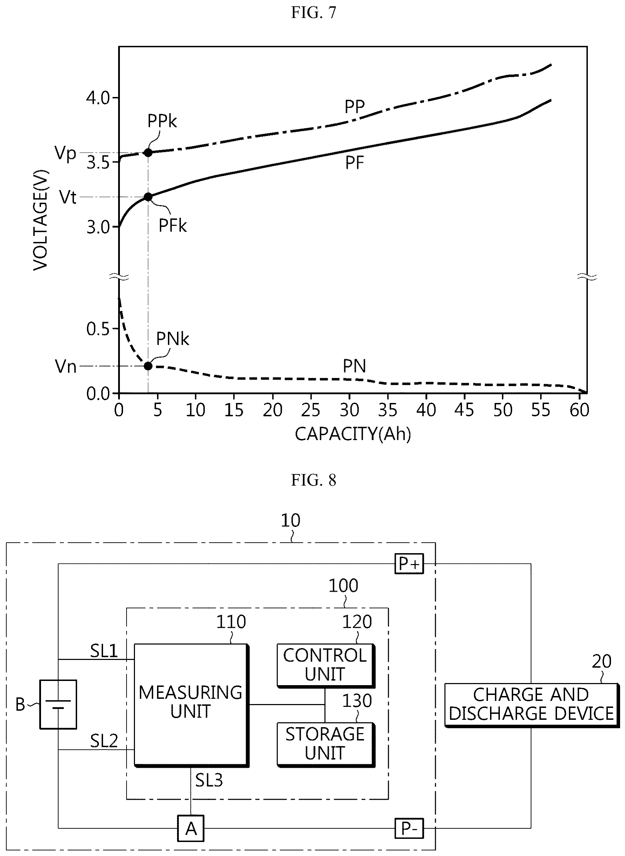

Below, the target voltage is specifically set with reference to FIG. 7.

FIG. 7 is a drawing schematically illustrating a criterion profile of a criterion battery according to an embodiment of the present disclosure.

The target voltage may be preset as a voltage of the criterion battery corresponding to a negative electrode potential at which the change rate of the negative electrode potential with respect to the capacity is equal to the preset reference change rate in the negative electrode criterion profile PN of the criterion battery.

For example, the criterion battery may be a three-electrode cell. Preferably, the composition of the positive electrode of the three-electrode cell may be the same as the composition of the positive electrode of the battery. Also, the composition of the negative electrode of the three-electrode cell may be the same as the composition of the negative electrode of the battery.

Also, the criterion profile may include a positive electrode criterion profile PP and a negative electrode criterion profile PN. Here, the positive electrode criterion profile PP is a profile representing the correspondence between the capacity and voltage for the positive electrode of the three-electrode cell. Also, the negative electrode criterion profile PN is a profile representing the correspondence between the capacity and voltage for the negative electrode of the three-electrode cell.

For example, in the embodiment of FIG. 7, the criterion profile may include a positive electrode criterion profile PP and a negative electrode criterion profile PN. Then, a full cell criterion profile PF may be derived based on the positive electrode criterion profile PP and the negative electrode criterion profile PN. For example, for the same capacity, the potential difference between the positive electrode potential of the positive electrode criterion profile PP and the negative electrode potential of the negative electrode criterion profile PN may be expressed as a voltage of the full cell criterion profile PF.

In the embodiment of FIG. 7, it is assumed that the change rate of the negative electrode potential for the capacity at the PNk point of the negative electrode criterion profile PN is the same as the reference change rate. The negative electrode potential corresponding to the PNk point of the negative electrode criterion profile PN is Vn. Also, the point corresponding to the PNk point in the positive electrode criterion profile PP is the PPk point, and the positive electrode potential corresponding to the PPk point is Vp. Also, the point corresponding to the PNk point in the full cell criterion profile PF is the PFk point, and the target voltage corresponding to the PFk point is Vt. Here, it may be calculated according to the formula "Vt = Vp - Vn".

When available lithium is lost, the start potential of the negative electrode participating in the charge and discharge reaction may shift toward the high potential side. That is, as available lithium is lost, the negative electrode potential corresponding to the target voltage may increase rapidly. For example, referring to FIG. 7, initially, the negative electrode potential corresponding to the target voltage (Vt) is Vn, but as available lithium is lost, the negative electrode potential corresponding to the target voltage (Vt) may increase rapidly more than Vn. In addition, when the negative electrode potential increases rapidly, the capacity difference between the full discharge capacity and the target discharge capacity may decrease rapidly. For example, the rapid decrease in the capacity difference is as illustrated in FIG. 3. In addition, whether the capacity difference decreases rapidly may be confirmed through a comparison between the capacity difference change rate and the criterion change rate.

The loss of available lithium causes lithium plating, and lithium plating causes swelling of the battery. Also, the swelling of the battery causes sudden death of the battery. Therefore, the apparatus 100 for diagnosing a battery may diagnose a battery having a risk of sudden death based on the target voltage set with reference to the negative electrode criterion profile PN.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the measuring unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

FIG. 8 is a diagram schematically showing an exemplary configuration of a battery pack 10 according to another embodiment of the present disclosure.

The positive electrode terminal of the battery B may be connected to the positive electrode terminal P+ of the battery pack 10, and the negative electrode terminal of the battery B may be connected to the negative electrode terminal P- of the battery pack 10.

The measuring unit 110 may be connected to the first sensing line SL1, the second sensing line SL2, and the third sensing line SL3. Specifically, the measuring unit 110 may be connected to the positive electrode terminal of the battery B through the first sensing line SL1, and may be connected to the negative electrode terminal of the battery B through the second sensing line SL2. The measuring unit 110 may measure the voltage of the battery B based on the voltage measured from each of the first sensing line SL1 and the second sensing line SL2.

Also, the measuring unit 110 may be connected to the current measurement unit A through the third sensing line SL3. For example, the current measurement unit A may be a current meter or a shunt resistor capable of measuring the charge current and discharge current of the battery B. The measuring unit 110 may measure the charge current of the battery B through the third sensing line SL3 and calculate the charge amount. In addition, the measuring unit 110 may measure the discharge current of the battery B through the third sensing line SL3 and calculate the discharge amount.

The charge and discharge device 20 may have one end connected to the positive electrode terminal (P+) of the battery pack 10, and the other end connected to the negative electrode terminal (P-) of the battery pack 10. Accordingly, the positive electrode terminal of the battery B, the positive electrode terminal (P+) of the battery pack 10, the charge and discharge device 20, the negative electrode terminal (P-) of the battery pack 10, and the negative electrode terminal of the battery B may be electrically connected.

For example, the charge and discharge device 20 may receive a charge start command, a charge end command, a discharge start command, and a discharge end command from the control unit 120. That is, the charge and discharge device 20 may charge and discharge the battery B based on the commands received from the control unit 120.

In another embodiment, the charge and discharge device 20 may be included in the apparatus 100 for diagnosing a battery. That is, the apparatus 100 for diagnosing a battery may diagnose the state of the battery B by directly charging and discharging the battery B using the charge and discharge device 20. For example, the control unit 120 and the charge and discharge device 20 may be communicatively connected. Also, the charge and discharge device 20 may charge and discharge the battery B based on the commands received from the control unit 120.

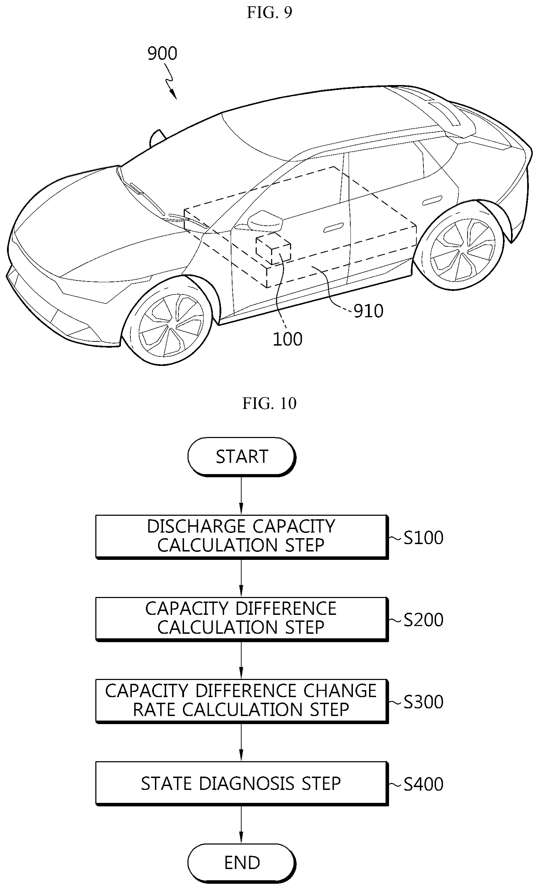

FIG. 9 is a diagram schematically showing a vehicle 900 according to another embodiment of the present disclosure.

Referring to FIG. 9, the battery pack 910 according to an embodiment of the present disclosure may be included in a vehicle 900 such as an electric vehicle (EV) or a hybrid vehicle (HV). Additionally, the battery pack 910 may drive the vehicle 900 by supplying power to the motor through an inverter provided in the vehicle 900. Here, the battery pack 910 may include the apparatus 100 for diagnosing a battery.

For example, in the embodiment of FIG. 9, the vehicle 900 may include the battery pack 910 and the apparatus 100 for diagnosing a battery.

FIG. 10 is a diagram schematically showing a method for diagnosing a battery according to still another embodiment of the present disclosure.

Preferably, each step of the method for diagnosing a battery may be performed by the apparatus 100 for diagnosing a battery. Hereinafter, for convenience of explanation, the content overlapping with the previously described content will be briefly described or omitted.

The discharge capacity calculation step (S100) is a step of calculating the target discharge capacity until the voltage of the battery reaches the target voltage and calculating the full discharge capacity of the battery, and may be performed by the control unit 120.

For example, the control unit 120 may calculate the target discharge capacity by accumulating the discharge current amount until the battery voltage reaches the target voltage from the charge end voltage. In addition, the control unit 120 may calculate the full discharge capacity by accumulating the discharge current amount until the battery voltage reaches the discharge end voltage from the charge end voltage.

The capacity difference calculation step (S200) is a step for calculating the capacity difference between the full discharge capacity and the target discharge capacity, and may be performed by the control unit 120.

For example, the control unit 120 may calculate the capacity difference of the current time point by calculating the formula of "full discharge capacity - target discharge capacity".

In the embodiment of FIG. 6, the control unit 120 may calculate the first capacity difference (ΔQ1) of the first time point (t1), the second capacity difference (ΔQ2) of the second time point (t2), the third capacity difference (ΔQ3) of the third time point (t3), and the fourth capacity difference (ΔQ4) of the fourth time point (t4).

The capacity difference change rate calculation step (S300) is a step of calculating the capacity difference change rate based on the calculated capacity difference and the preset capacity difference profile, and may be performed by the control unit 120.

For example, the control unit 120 may calculate a capacity difference change rate between the capacity difference of the current time point and the capacity difference of the previous time point.

In the embodiment of FIG. 6, the control unit 120 may calculate the second capacity difference change rate (QR2) according to the change rate of the second capacity difference (ΔQ2) of the second time point (t2) and the first capacity difference (AQ1) of the first time point (t1). The control unit 120 may calculate the third capacity difference change rate (QR3) according to the change rate of the second capacity difference (ΔQ3) of the third time point (t3) and the second capacity difference (ΔQ2) of the second time point (t2). The control unit 120 may calculate the fourth capacity difference change rate (QR4) according to the change rate of the fourth capacity difference (ΔQ4) of the fourth time point (t4) and the third capacity difference (ΔQ3) of the third time point (t3).

The state diagnosis step (S400) is a step for diagnosing the state of the battery based on the calculated capacity difference change rate and the preset criterion change rate, and may be performed by the control unit 120.

For example, the control unit 120 may diagnose the state of the battery by comparing the size between the calculated capacity difference change rate and the preset criterion change rate. If the calculated capacity difference change rate is less than the criterion change rate, the control unit 120 may be configured to diagnose the state of the battery as a normal state. Conversely, if the calculated capacity difference change rate is greater than or equal to the criterion change rate, the control unit 120 may be configured to diagnose the state of the battery as an abnormal state.

In the embodiment of FIG. 6, the control unit 120 may diagnose the state of the battery at the third time point (t3) based on the result of comparing the third capacity difference change rate (QR3) and the third criterion change rate (RR3). In addition, the control unit 120 may diagnose the state of the battery at the fourth time point (t4) based on the result of comparing the fourth capacity difference change rate (QR4) and the fourth criterion change rate (RR4).

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
20: charge and discharge device
100: apparatus for diagnosing a battery
110: measuring unit
120: control unit
130: storage unit
900: vehicle
910: battery pack

## Claims

1. An apparatus for diagnosing a battery, comprising:
a measuring unit configured to measure voltage and current of a battery; and
a control unit configured to calculate a target discharge capacity until the voltage of the battery reaches a target voltage, calculate a full discharge capacity of the battery, calculate a capacity difference between the full discharge capacity and the target discharge capacity, calculate a capacity difference change rate based on the calculated capacity difference and a preset capacity difference profile, and diagnose a state of the battery based on the calculated capacity difference change rate and a preset criterion change rate.

2. The apparatus for diagnosing a battery according to claim 1,
wherein the control unit is configured to diagnose the state of the battery as a normal state when the calculated capacity difference change rate is less than the criterion change rate, and
wherein the control unit is configured to diagnose the state of the battery as an abnormal state when the calculated capacity difference change rate is greater than or equal to the criterion change rate.

3. The apparatus for diagnosing a battery according to claim 2,
wherein the control unit is configured to diagnose the battery diagnosed as in the abnormal state as a battery having a risk of sudden death.

4. The apparatus for diagnosing a battery according to claim 1,
wherein the control unit is configured to determine a capacity difference of a previous time point from the capacity difference profile, and calculate a change rate between the calculated capacity difference and the capacity difference of the previous time point to calculate the capacity difference change rate.

5. The apparatus for diagnosing a battery according to claim 4,
wherein the control unit is configured to calculate a capacity difference change rate of the previous time point based on the capacity difference profile and set the criterion change rate as a value obtained by multiplying the capacity difference change rate of the previous time point by a preset criterion ratio.

6. The apparatus for diagnosing a battery according to claim 5,
wherein the criterion ratio is set as a ratio between a capacity difference change rate at a time point where sudden death occurs in a preset reference battery and a capacity difference change rate at a time point immediately before the sudden death occurs.

7. The apparatus for diagnosing a battery according to claim 1,
wherein the target voltage is preset as a voltage of a criterion battery corresponding to a negative electrode potential at which a change rate of a negative electrode potential with respect to the capacity is equal to a preset reference change rate in a negative electrode criterion profile of the criterion battery.

8. A battery pack comprising the apparatus for diagnosing a battery according to any one of claims 1 to 7.

9. A vehicle comprising the apparatus for diagnosing a battery according to any one of claims 1 to 7.

10. A method for diagnosing a battery, comprising:
a discharge capacity calculation step of calculating a target discharge capacity until a voltage of a battery reaches a target voltage and calculating a full discharge capacity of the battery;
a capacity difference calculation step of calculating a capacity difference between the full discharge capacity and the target discharge capacity;
a capacity difference change rate calculation step of calculating a capacity difference change rate based on the calculated capacity difference and a preset capacity difference profile; and
a state diagnosis step of diagnosing a state of the battery based on the calculated capacity difference change rate and a preset criterion change rate.
